# EUROPÄISCHE PATENTSCHRIFT

(11) **EP 1 244 340 B1**
(45) Veröffentlichungstag und Bekanntmachung des Hinweises auf die Patenterteilung: **11.10.2006**
(21) Anmeldenummer: 02005721.2
(22) Anmeldetag: 13.03.2002
(51) Int. Cl.: H05K 7/14, H02M 7/00

(54) **Aus mehreren Leistungsmodulen bestehende elektronische Leistungsschaltung**
Electronic power circuit comprising several power modules
Circuit de puissance électronique comprenant plusieurs modules de puissance

(30) Priorität: 22.03.2001 DE 10114125
(43) Veröffentlichungstag der Anmeldung: 25.09.2002
(73) Patentinhaber: TEMIC Automotive Electric Motors GmbH, 10553 Berlin (DE)
(72) Erfinder: Schmid, Ralf, 87662 Kaltental (DE); Schmidt, Marco, 86899 Landsberg (DE); Sontheim, Johann, 82346 Andechs (DE); Perkounigg, Helmut, 82362 Weilheim (DE)
(74) Vertreter: Pröll, Jürgen

(56) Entgegenhaltungen:
- DE-A- 4 116 826
- DE-A- 19 937 671
- US-A- 4 975 825
- US-A- 5 539 254

## Beschreibung

Die vorliegende Erfindung betrifft eine aus mehreren Leistungsmodulen bestehende elektronische Leistungsschaltung nach dem Oberbegriff des Anspruchs 1.

Derzeit stehen zwei Aspekte bei der Gestaltung von aus mehreren Leistungsmodulen bestehenden elektronischen Leistungsschaltungen im Vordergrund. Einerseits müssen die Verfahrensschritte zur Herstellung der elektronischen Leistungsschaltungen immer rationeller ausführbar sein und einen immer höheren Automatisierungsgrad besitzen. Andererseits werden immer weitergehende Anforderungen an die Zuverlässigkeit und Einsatzbreite bei einem minimierten Platz- und Volumenbedarf gestellt.

Die gattungsgemäßen elektronischen Leistungsschaltungen werden insbesondere zur Steuerung einer elektrischen Maschine und zur Erzeugung elektrischer Energie verwendet. Die erzeugte elektrische Energie wird verschiedensten Verbrauchern zur Verfügung gestellt, die üblicherweise in elektrischen Netzen zusammengefasst sind. Solche elektrischen Netze werden beispielsweise als Bordnetze für Fahrzeuge verwendet. Insbesondere, wenn eine elektrische Maschine in einem Fahrzeug verwendet wird, steht üblicherweise nur ein geringer Bauraum zur Verfügung.

Aus der DE 199 13 450 A1 ist eine Leistungselektronik zum Steuern einer elektrischen Maschine bekannt. Die Leistungselektronik umfasst ein Leistungsteil, das eine Anzahl von Kondensatoren und eine Anzahl von Leistungshalbleitern aufweist, die mit einer Leistungsverschienung verbunden sind. Außerdem ist eine Kühlvorrichtung vorgesehen, die derart mit den Kondensatoren und/oder den Leistungshalbleitern verbunden ist, dass zwischen diesen und der Kühlvorrichtung ein thermischer Austausch stattfindet oder stattfinden kann. Mehrere Leistungshalbleiter sind dabei nebeneinander mittels einer Klemmverbindung direkt auf der Oberfläche der von einer Kühlflüssigkeit durchflossenen Kühlvorrichtung angeordnet. Der Wärmeaustausch zwischen den Leistungshalbleitern und der Kühlflüssigkeit erfolgt über die metallische Oberfläche der Kühlvorrichtung.

Nachteilig daran ist, dass die Leistungshalbleiter direkt auf der Oberfläche der Kühlvorrichtung aufliegen bzw. sich mit dieser in gleicher Ebene befinden. Daher müssen die Leistungshalbleiter elektrisch von der Kühlvorrichtung isoliert werden. Die zwischen den Leistungshalbleitern und dem Kühlkörper angeordnete elektrisch isolierende Fläche behindert aber den freien Wärmeaustausch zwischen Leistungshalbleiter und Kühlvorrichtung. Das Dilemma besteht demnach in der Wahl einer guten elektrischen Isolierung oder einem direkten Wärmeaustausch.

Eine andere aus mehreren Leistungsmodulen bestehende elektronische Leistungsschaltung ist durch die US-A-4 975 825 bekannt.

Der Erfindung liegt die Aufgabe zugrunde, eine Leistungsschaltung der eingangs genannten Art anzugeben, die sich durch einen deutlich vereinfachten und kompakteren Aufbau auszeichnet, einen verbesserten Wärmeaustausch ermöglicht und sich vereinfacht, weitestgehend automatisiert herstellen lässt.

Diese Aufgabe wird bei einer aus mehreren Leistungsmodulen bestehenden elektronischen Leistungsschaltung der eingangs genannten Art mit den Merkmalen des Anspruchs 1 gelöst. Weiterbildungen und vorteilhafte Ausgestaltungen ergeben sich aus den Unteransprüchen.

Jedes Leistungsmodul umfasst bei der Erfindung eine plattenförmige integrierte elektronische Schaltungsanordnung mit mehreren elektrischen Anschlüssen. Erfindungsgemäß ist an jeder von zwei gegenüberliegenden Seiten der plattenförmigen Schaltungsanordnung ein senkrecht umgebogener elektrisch leitender Seitenschenkel angeordnet, welcher einen elektrischen Anschluss bildet und wodurch das Leistungsmodul einen U-förmigen Querschnitt aufweist. Jeder Seitenschenkel ist mit Verbindungsmitteln versehen, durch welche zwei oder mehrere Leistungsmodule unter Bildung eines gegenseitigen Abstandes zwischen den plattenförmigen Schaltungsanordnungen über die Seitenschenkel zur Bildung der elektronischen Leistungsschaltung elektrisch und mechanisch fest miteinander verbunden sind.

Die erfindungsgemäße Leistungsschaltung zeichnet sich durch die Anordnung und Ausgestaltung der einzelnen Leistungsmodule aus. Diese lassen sich vorteilhaft turmartig übereinander stapeln.

Durch die Anordnung der einzelnen Leistungsmodule wird eine kompakte Leistungsschaltung mit geringem Platzbedarf geschaffen. Mit den erfindungsgemäß aufgebauten Leistungsmodulen lässt sich dabei sehr schnell und flexibel eine an unterschiedliche Anforderungen angepasste elektronische Leistungsschaltung herstellen.

Zudem zeichnet sich die erfindungsgemäße Leistungsschaltung durch einen sehr einfachen und auch einfach herzustellenden Aufbau aus. Eine derartige Leistungsschaltung kann weitestgehend automatisiert hergestellt werden.

Beim Betrieb der Leistungsschaltung entsteht eine Verlustwärme, welche abgeführt werden muss, da die Leistungsschaltung sonst zerstört werden könnten. Insgesamt zeichnet sich die erfindungsgemäße Leistungsschaltung durch eine verbesserte Wärmeabfuhr aus. Der erfindungsgemäße Aufbau der Leistungsmodule ist besonders für eine Luftkühlung geeignet, bei der die sonst üblichen, apparativ aufwendigen Kühlmittelanschlüsse entfallen.

Dabei bildet der durch die Seitenschenkel eines Leistungsmoduls begrenzte Raum einen Kühlkanal, in dem ein Kühlmedium zu- und abgeführt werden kann. Das Kühlmedium, zum Beispiel eine Siedebadkühlung steht mit den Leistungsmodulen im direkten thermischen Kontakt, so dass ein direkter thermischer Austausch zwischen Kühlmedium und Leitungsmodul stattfindet und die Verlustwärme abgeführt wird.

Außerdem sind gegenüber dem herkömmlichen Stand der Technik weniger Teile zum Aufbau einer Leistungsschaltung notwendig. Dies führt vorteilhaft zu einer Gewichtsreduzierung.

Ein weiterer Vorteil liegt in der besonders guten Steifigkeit der Leistungsschaltung, die durch den räumlichen, dreidimensionalen Aufbau der Leistungsmodule hervorgerufen wird.

Die Leistungsmodule können beispielsweise Leistungshalbleiter wie MOSFETs, IGBTs oder dergleichen sein. Die Auswahl der geeigneten Leistungshalbleiter erfolgt nach den Leistungsanforderungen an die Leistungsschaltung. Soll die Leistungsschaltung beispielsweise im Rahmen eines 42-V-Bordnetzes eines Kraftfahrzeuges verwendet werden , eignen sich vorzugsweise MOSFETs. IGBTs werden dagegen bei noch höheren Spannungen eingesetzt.

Eine Weiterbildung sieht vor, dass der Seitenschenkel unterhalb der Biegung einen parallel zur Biegungslinie verlaufenden nach außen stehenden Vorsprung aufweist, auf den ein weiterer Seitenschenkel mit der Unterseite aufsteckbar ist, wobei sich die aufeinander gesteckten Seitenschenkel teilweise überlappen.

Dadurch wird eine Vorfixierung der aufeinander gesteckten und zu verbindenden Leistungsmodule zur elektronischen Leistungsschaltung erreicht. Der Vorsprung bildet eine Zentrierhilfe für das automatisierte Aufeinanderstecken, der sogenannten Paketierung der Leistungsmodule zu sogenannten Stacks, also zu einem stapelförmigen Aufbau..

Vorzugsweise weist der Seitenschenkel in der Biegung wenigstens eine Ausnehmung mit einer darin angeordneten Lippe und an der Unterseite wenigstens eine das passgenaue Gegenstück zur Lippe bildende Ausnehmung auf.

Auch dadurch lassen sich die aufeinander gesteckte Module vorfixieren.

Alternativ ist vorgesehen, dass der Seitenschenkel an der Unterseite wenigstens eine Ausnehmung mit einer darin angeordneten, nach innen gebogenen Lippe und in der Biegung eine das passgenaue Gegenstück zur Lippe bildende Ausnehmung aufweist.

Beim Aufstecken eines Leistungsmoduls auf ein anderes rastet die nach innen gebogenen Lippe der Seitenschenkel des einen Leistungsmoduls in die die Ausnehmung des anderen Leistungsmoduls ein. Eine derartige Vorfixierung übt eine stabilisierende Wirkung auf den Gesamtaufbau der Leistungsschaltung aus.

Anschließend werden die aufeinander angeordneten Seitenschenkel durch einen Schweißoder Lötprozess, insbesondere durch einen Widerstandsschweißprozess elektrisch leitendend verbunden.

Durch einen derartigen Schweiß- oder Lötprozess werden die Seitenschenkel stoffschlüssig und damit elektrisch leitend miteinander verbunden.

Weiterhin ist vorgesehen, dass die Seitenschenkel derart ausgebildet sind, dass wenigstens ein elektrisches Bauteil, insbesondere ein Kondensator, in den durch die Seitenschenkel begrenzten Raum einbringbar ist.

Dadurch ist eine einfache, platzsparende Anordnung der elektrischen Bauteile möglich, ohne dass die Ausmaße der Leistungsschaltung verändert werden müssen.

Eine derartige Anordnung eines elektrischen Bauteils ist auch vorteilhaft, weil dadurch eine Kühlung des Bauteils gewährleistet wird. Das elektrische Bauteil befindet sich im Kühlkanal und daher im direkten thermischen Kontakt mit der Kühlluft. Dadurch kann die während des Betriebes des elektrischen Bauteils entstehende Verlustwärme abgeführt werden.

Da die Ausgestaltung der Leistungsschaltung sehr stark von der erforderlichen Spannungsebene abhängig ist, kann die Anzahl der elektrischen Bauteile wie Kondensatoren und die Anzahl der Leistungsmodule je nach Auslegung der Leistungsschaltung variieren. Insbesondere durch die modulare Bauweise ist es möglich, die Leistungsschaltung den gewünschten Bedingungen anzupassen, und die Leistung zu scalieren.

In einer weiteren vorteilhaften Ausgestaltung der Erfindung weist das Bauteil zwei seitliche elektrische Kontaktschienen auf, die derart mit dem oberhalb der Biegung liegenden Bereich der Seitenschenkeln verbindbar sind, dass das Bauteil über der plattenförmigen Schaltungsanordnung angeordnet ist.

Durch die Anordnung des elektrischen Bauteils im Abstand zur Schaltungsanordnung wird eine einfache Kühlung der Schaltungsanordnung und des elektrischen Bauteils erreicht. Das elektrische Bauteil muss dabei nicht gegenüber der Schaltungsanordnung elektrisch isoliert werden.

Vorzugsweise sind auf dem Seitenschenkel oberhalb der Biegung Erhebungen für das Verbinden mit der Kontaktschiene durch Buckelschweißung angeordnet.

Eine Weiterbildung sieht vor, dass die Seitenschenkel mit anderen elektrischen Bauteilen, mit einem Stromversorgungsnetz und/oder mit einem Verbraucher elektrisch verbindbar sind.

Vorzugsweise ist die Schaltungsanordnung in einem Kunststoff, insbesondere in Epoxidharz oder Gel eingebettet.

Dieser dient als Isolierungsmaterial und sollte eine sehr gute Temperaturbeständigkeit sowie Wärmeleitfähigkeit aufweisen.

In einer Weiterbildung sind an wenigstens einer der schenkellosen Seiten der Schaltungsanordnung elektrische Kontakte, insbesondere Leistungs- und Signalkontakte angeordnet.

Außerdem ist vorgesehen, dass die Seitenschenkel an wenigstens einer Querseite mit elektrisch leitenden Verbindungsstiften zum Anlöten auf einer Leiterplatte ausgebildet sind.

Weiterhin können die Seitenschenkel an wenigstens einer Querseite mit einem elektrischen Kontakt zum Anschluss an eine Stromschiene ausgebildet sein.

Schließlich ist vorgesehen, wenigstens ein erfindungsgemäßes Leistungsmodul in einer Leistungselektronik zum Steuern einer an sich bekannten Asynchronmaschine zu verwenden, die das Herzstück eines Kurbelwellenstartergenerators (KSG) ist.

KSG ist eine Kombination aus Anlasser und Generator (Lichtmaschine) und ggfs auch einem Schwingungsdämpfer. Mit einem derartigen KSG kann der von der Automobilindustrie erwartete höhere Energiebedarf zukünftiger Fahrzeuggenerationen gedeckt werden, beispielsweise durch eine Steigerung der heutigen Batteriespannung von 14 Volt um das dreifache auf 42 Volt. Erreicht wird dies mit einem Asynchron-Elektromotor, der als elektromechanisches Stellglied des Systems KSG direkt an die Kurbelwelle angeflanscht ist. Es ersetzt das bisher übliche Schwungrad und braucht nur unbedeutend mehr Platz.

Die erfindungsgemäßen Leistungsmodule der Leistungsschaltung sind derart platzsparend angeordnet, dass ein KSG-System mit geringem Aufwand in bestehende Antriebsstränge integriert werden kann. Die effiziente Kühlung der Leistungsmodule erlaubt eine kompakte Bauweise.

Nachfolgend wird die Erfindung anhand von Ausführungsbeispielen erläutert, die in der Zeichnung dargestellt sind. In dieser zeigen:
- Fig. 1: eine perspektivische Ansicht eines erfindungsgemäßen Leistungsmoduls,
- Fig. 2: eine Seitenansicht zweier aufeinander gesteckter Leistungsmodule,
- Fig. 3: eine Querschnittsansicht zweier schematisch aufeinander gesteckter Leistungsmodule und
- Fig. 4: eine Querschnittsansicht des Seitenschenkels eines erfindungsgemäßen Leistungsmoduls.

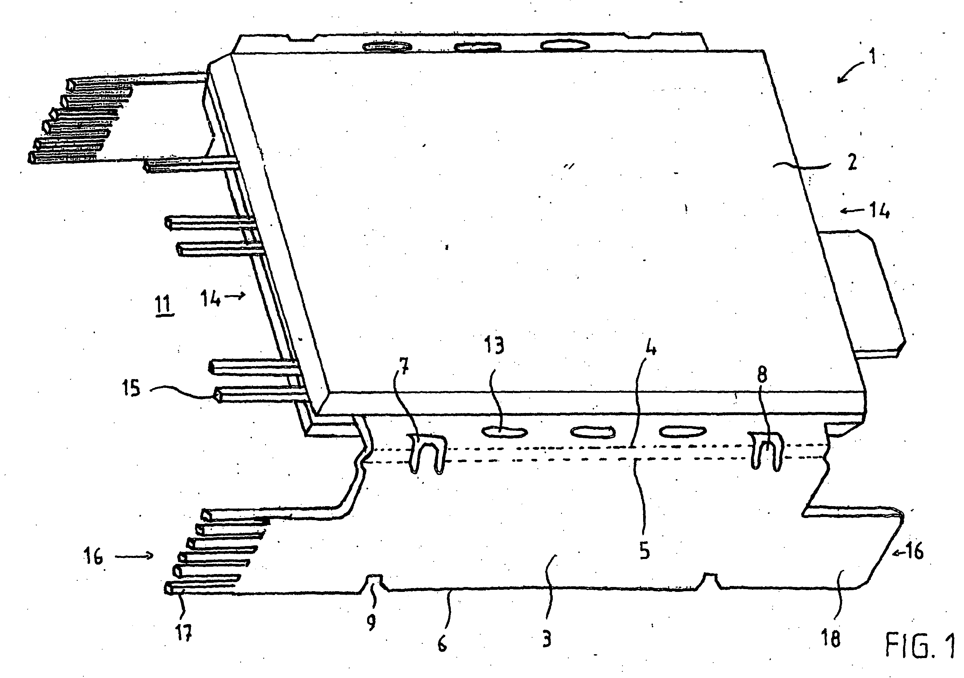

Fig. 1 zeigt eine perspektivische Ansicht des erfindungsgemäßen Leistungsmoduls 1. Das Leistungsmodul 1 besteht aus einer plattenförmigen integrierten elektronischen Schaltungsanordnung 2 mit mehreren elektrischen Anschlüssen 15. Erfindungsgemäß ist an zwei gegenüberliegenden Seiten der plattenförmigen Schaltungsanordnung 2 ein senkrecht umgebogener elektrisch leitender Seitenschenkel 3 angeordnet, welcher einen elektrischen Anschluss bildet.

Die Seitenschenkel 3 weisen unterhalb der Biegung 4 einen parallel zur Biegungslinie verlaufenden nach außen stehenden Vorsprung 5 aufweist, auf den ein weiterer Seitenschenkel 3 mit der Unterseite 6 aufsteckbar ist.

Der Seitenschenkel 3 hat in der in der Biegung 4 zwei Ausnehmungen 7 mit je einer darin angeordneten Lippe 8 und an der Unterseite 6 zwei die passgenauen Gegenstücke zur Lippe 8 bildenden Ausnehmungen 9.

Weiterhin sind auf den Seitenschenkeln 3 oberhalb der Biegung 4 Erhebungen 13 angeordnet. Diese sind für eine Buckelschweißung vorgesehen, durch die das Leistungsmodul 1 mit einem elektrischen Bauteil, beispielsweise einem Kondensator, stoffschlüssig zusammengefügt werden kann.

Ferner sind an einer schenkellosen Seite 14 der Schaltungsanordnung 2 elektrische Kontakte 15, insbesondere Leistungs- und Signalkontakte angeordnet. Die Seitenschenkel 3 sind an einer Querseite 16 mit elektrisch leitenden Verbindungsstiften 17 zum Anlöten auf einer hier nicht dargestellten Leiterplatte ausgebildet. An der gegenüberliegenden Querseite 16 der Seitenschenkel 3 ist einen elektrischen Kontakt 18 zum Anschluss an eine hier nicht dargestellte Stromschiene vorgesehen.

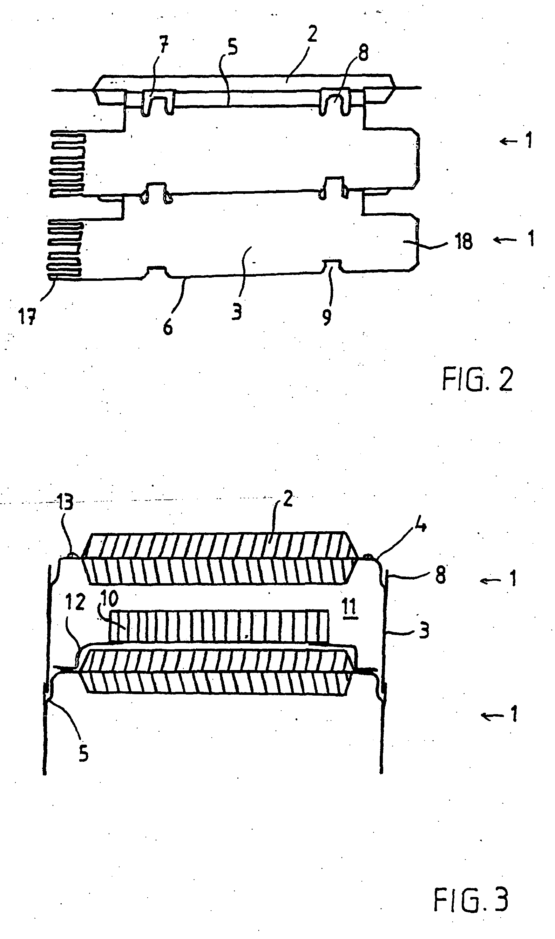

Fig. 2 zeigt eine Seitenansicht zweier aufeinander gesteckter Leistungsmodule 1. Dargestellt ist der überraschend einfache und auch einfach herzustellende Aufbau.

Dabei sind die Seitenschenkel 3 des oberen Leitungsmoduls 1 auf den nach außen stehenden Vorsprung 5 der Seitenschenkel 3 des unteren Leistungsmoduls 1 gesteckt, wobei sich die aufeinander gesteckten Seitenschenkel 3 teilweise überlappen.

Dadurch wird eine Vorfixierung der aufeinander gesteckten und zu verbindenden Leistungsmodule 1 zur elektronischen Leistungsschaltung erreicht. Der Vorsprung 5 bildet eine Zentrierhilfe für das automatisierte Aufeinanderstecken, der sogenannten Paketierung der Leistungsmodule 1 zu sogenannten Stacks.

Die Seitenschenkel weisen außerdem in der Biegung jeweils zwei Ausnehmungen 7 mit je einer darin angeordneten Lippe 8 und an der Unterseite 6 jeweils eine das passgenaue Gegenstück zur Lippe 8 bildende Ausnehmung 9 auf. Auch dadurch lassen sich die aufeinander gesteckte Leistungsmodule 1 vorfixieren. Ein seitliches Verrutschen der aufeinander gesteckten Leistungsmodule1 wird verhindert.

Anschließend werden die aufeinander angeordneten Seitenschenkel 3 durch einen Schweiß- oder Lötprozess stoffschlüssig und damit mechanisch und elektrisch leitendend verbunden.

Dargestellt sind auch die an einer Querseite des Seitenschenkels 3 ausgebildeten elektrisch leitenden Verbindungsstifte 17 zum Anlöten auf einer hier nicht dargestellten Leiterplatte und die elektrischen Kontakte 19 zum Anschluss an eine hier nicht dargestellte Stromschiene.

Fig. 3 zeigt eine schematische Querschnittsansicht zweier aufeinander gesteckter Leistungsmodule 1.

Jedes Leistungsmodul 1 umfasst eine plattenförmige Schaltungsanordnung 2. An zwei gegenüberliegenden Seiten der plattenförmigen Schaltungsanordnung 2 ist ein senkrecht umgebogener elektrisch leitender Seitenschenkel 3 angeordnet., wodurch das Leistungsmodul 1 einen U-förmigen Querschnitt aufweist. Die Leistungsmodule 1 sind unter Bildung eines gegenseitigen Abstandes zwischen den plattenförmigen Schaltungsanordnungen 2 über die Seitenschenkel 3 zur Bildung der elektronischen Leistungsschaltung aufeinander gesteckt, aber noch nicht fest miteinander verbunden.

Jeder Seitenschenkel 3 weist unterhalb der Biegung 4 einen parallel zur Biegungslinie verlaufenden nach außen stehenden Vorsprung 5 auf. In Fig. 3 sind die Unterseiten der Seitenschenkel 3 des oberen Leistungsmoduls 1 auf den Vorsprung 5 der Seitenschenkel 3 des unteren Leistungsmoduls 1 aufgesteckt. Der Übersicht halber ist das direkte Aufliegen der Seitenschenkel 3 auf dem jeweiligen Vorsprung 5 nur angedeutet. Zu erkennen ist, dass sich die aufeinander gesteckten Seitenschenkel 3 teilweise überlappen. Weiterhin weist jeder Seitenschenkel 3 in der Biegung 4 wenigstens eine hier nicht dargestellte Ausnehmung mit einer darin angeordneten Lippe 8 und an der Unterseite wenigstens eine das passgenaue Gegenstück zur Lippe 8 bildende hier ebenfalls nicht dargestellte Ausnehmung auf.

Sowohl durch die Vorsprünge 5 als auch durch die Ausnehmungen und Lippen 8 wird eine Vorfixierung der aufeinander gesteckten und zu verbindenden Leistungsmodule 1 zur elektronischen Leistungsschaltung erreicht. Anschließend können die aufeinander gesteckten Seitenschenkel 3 durch einen automatisierten Schweiß- oder Lötprozess miteinander elektrisch und mechanisch verbunden werden.

Weiterhin ist ein elektrisches Bauteil 10, beispielsweise ein Kondensator, in den durch die Seitenschenkel 3 begrenzten Raum 11 eingebracht. Das elektrische Bauteil 10 weist zwei seitliche elektrische Kontaktschienen 12 auf, die mit dem oberhalb der Biegung 4 liegenden Bereich der Seitenschenkeln 3 über eine Buckelschweißung verbunden sind. Auf den Seitenschenkeln 3 oberhalb der Biegung 4 sind zu diesem Zweck Erhebungen 13 angeordnet.

Es ist gut zu erkennen, dass die beim Betrieb der Leistungsschaltung entstehende Verlustwärme einfach abgeführt werden kann. Der erfindungsgemäße Aufbau der Leistungsmodule1 ist besonders für eine Luftkühlung geeignet, bei der die sonst üblichen, apparativ aufwendigen Kühlmittelanschlüsse entfallen.

Dabei bildet der durch die Seitenschenkel 3 eines Leistungsmoduls 1 begrenzte Raum 11 einen Kühlkanal, in dem Kühlluft zu- und abgeführt werden kann. Die Kühlluft steht mit den Leistungsmodulen 1 im direkten thermischen Kontakt, so dass ein direkter thermischer Austausch zwischen Kühlluft und Leitungsmodul 1 stattfindet und die Verlustwärme abgeführt wird.

Die erfindungsgemäße Anordnung des elektrischen Bauteils 10 ist auch vorteilhaft, weil sich dieses direkt im Kühlkanal befindet und daher im direkten thermischen Kontakt mit der Kühlluft steht. Dadurch kann die während des Betriebes des elektrischen Bauteils 10 entstehende Verlustwärme abgeführt werden.

Durch die Anordnung des elektrischen Bauteils 10 im Abstand zur Schaltungsanordnung 2 wird eine einfache Kühlung der Schaltungsanordnung 2 und des elektrischen Bauteils 10 erreicht. Das elektrische Bauteil 10 muss dabei nicht gegenüber der Schaltungsanordnung 2 elektrisch isoliert werden.

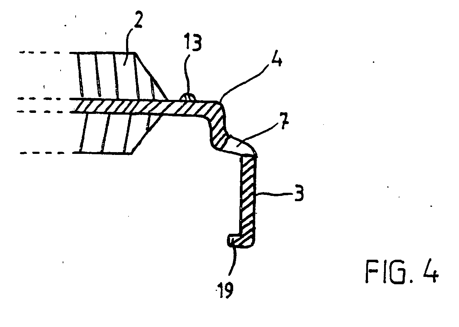

Fig. 4 zeigt schließlich eine Querschnittsansicht des alternativ ausgeführten Seitenschenkels 3 eines erfindungsgemäßen Leistungsmoduls 1.

Ein derart ausgebildeter Seitenschenkel 3 weist an der Unterseite eine nach innen gebogenen Lippe 19 und in der Biegung 4 eine das passgenaue Gegenstück zur Lippe 19 bildende Ausnehmung 7 auf.

Beim Aufstecken eines Leistungsmoduls 1 auf ein anderes rastet die nach innen gebogenen Lippe 19 des Seitenschenkels 3 des einen Leistungsmoduls 1 in die Ausnehmung 7 eines anderen Leistungsmoduls 1 ein. Eine derartige Vorfixierung übt eine stabilisierende Wirkung auf den Gesamtaufbau der Leistungsschaltung aus.

Dargestellt ist außerdem eine oberhalb der Biegung 4 angeordnete Erhebung 13 für die Buckelschweißung. Die Schaltungsanordnung 2 ist nur angedeutet.

Selbstverständlich ist die Erfindung nicht auf die oben beschriebenen und in der Figur dargestellte Ausführungsbeispiele beschränkt. Insbesondere können auch mehr als zwei Leistungsmodule und andere elektrische Bauteile die elektronische Leistungsschaltung bilden.

### Bezugszeichenliste (ist Bestandteil der Beschreibung)

- 1: Leistungsmodul
- 2: Schaltungsanordnung
- 3: Seitenschenkel
- 4: Biegung eines Seitenschenkels
- 5: Vorsprung
- 6: Unterseite eines Seitenschenkels
- 7: Ausnehmung in der Biegung
- 8: Lippe
- 9: Ausnehmung an der Unterseite
- 10: elektrisches Bauteil
- 11: Raum
- 12: Kontaktschienen
- 13: Erhebung
- 14: schenkelose Seite
- 15: elektrischer Kontakt
- 16: Querseite eines Seitenschenkels
- 17: Verbindungsstift
- 18: elektrischer Kontakt
- 19: Lippe

## Patentansprüche

1. Aus mehreren Leistungsmodulen (1) bestehende elektronische Leistungsschaltung, insbesondere zur Steuerung einer elektrischen Maschine, wobei jedes Leistungsmodul (1) eine plattenförmige integrierte elektronische Schaltungsanordnung (2) mit mehreren elektrischen Anschlüssen umfasst, **dadurch gekennzeichnet, dass** an jeder von zwei gegenüberliegenden Seiten der plattenförmigen Schaltungsanordnung (2) ein senkrecht umgebogener elektrisch leitender Seitenschenkel (3) angeordnet ist, welcher einen elektrischen Anschluss bildet und wodurch das Leistungsmodul (1) einen U-förmigen Querschnitt aufweist, und dass jeder Seitenschenkel (3) mit Verbindungsmitteln versehen ist, durch welche zwei oder mehrere Leistungsmodule (1) unter Bildung eines gegenseitigen Abstandes zwischen den plattenförmigen Schaltungsanordnungen (2) über die Seitenschenkel (3) zur Bildung der elektronischen Leistungsschaltung elektrisch und mechanisch fest miteinander verbunden sind.

2. Leistungsschaltung nach Anspruch 1, **dadurch gekennzeichnet, dass** der Seitenschenkel (3) unterhalb der Biegung (4) einen parallel zur Biegungslinie verlaufenden nach außen stehenden Vorsprung (5) aufweist, auf den ein weiterer Seitenschenkel (3) mit der Unterseite (6) aufsteckbar ist, wobei sich die aufeinander gesteckten Seitenschenkel (3) teilweise überlappen.

3. Leistungsschaltung nach Anspruch 1 oder 2, **dadurch gekennzeichnet, dass** der Seitenschenkel (3) in der Biegung (4) wenigstens eine Ausnehmung (7) mit einer darin angeordneten Lippe (8) und an der Unterseite (6) wenigstens eine das passgenaue Gegenstück zur Lippe (8) bildende Ausnehmung (9) aufweist.

4. Leistungsschaltung nach Anspruch 1 oder 2, **dadurch gekennzeichnet, dass** der Seitenschenkel (3) an der Unterseite (6) wenigstens eine Ausnehmung (9) mit einer darin angeordneten, nach innen gebogenen Lippe (19) und in der Biegung (4) eine das passgenaue Gegenstück zur Lippe (19) bildende Ausnehmung (7) aufweist.

5. Leistungsschaltung nach einem der Ansprüche 1 bis 4, **dadurch gekennzeichnet, dass** die übereinander angeordneten Seitenschenkel (3) durch einen Schweiß- oder Lötprozess, insbesondere durch einen Widerstandsschweißprozess elektrisch leitendend verbunden sind.

6. Leistungsschaltung nach einem der Ansprüche 1 bis 5, **dadurch gekennzeichnet, dass** die Seitenschenkel (3) derart ausgebildet sind, dass wenigstens ein elektrisches Bauteil (10), insbesondere ein Kondensator, in den durch die Seitenschenkel (3) begrenzten Raum (11) einbringbar ist.

7. Leistungsschaltung nach Anspruch 6, **dadurch gekennzeichnet, dass** das Bauteil (10) zwei seitliche elektrische Kontäktschienen (12) aufweist, die derart mit dem oberhalb der Biegung liegenden Bereich der Seitenschenkeln (3) verbindbar sind, dass das Bauteil (10) über der plattenförmigen Schaltungsanordnung (2) angeordnet ist.

8. Leistungsschaltung nach Anspruch 7, **dadurch gekennzeichnet, dass** auf dem Seitenschenkel (3) oberhalb der Biegung (4) Erhebungen (13) für das Verbinden mit der Kontaktschiene (12) durch Buckelschweißung angeordnet sind.

9. Leistungsschaltung nach einem der Ansprüche 1 bis 8, **dadurch gekennzeichnet, dass** die Seitenschenkel (3) mit anderen elektrischen Bauteilen, mit einem Stromversorgungsnetz und/oder mit einem Verbraucher elektrisch verbindbar sind.

10. Leistungsschaltung nach einem der Ansprüche 1 bis 9, **dadurch gekennzeichnet, dass** die Schaltungsanordnung (2) in einem Kunststoff, insbesondere Epoxidharz oder Gel, eingebettet ist.

11. Leistungsschaltung nach einem der Ansprüche 1 bis 10, **dadurch gekennzeichnet, dass** an wenigstens einer der schenkellosen Seiten (14) der Schaltungsanordnung (2) elektrische Kontakte (15), insbesondere Leistungs- und Signalkontakte, angeordnet sind.

12. Leistungsschaltung nach einem der Ansprüche 1 bis 11, **dadurch gekennzeichnet, dass** der Seitenschenkel (3) an wenigstens einer Querseite (16) mit elektrisch leitenden Verbindungsstiften (17) zum Anlöten auf einer Leiterplatte ausgebildet sind.

13. Leistungsschaltung nach einem der Ansprüche 1 bis 11, **dadurch gekennzeichnet, dass** der Seitenschenkel (3) an wenigstens einer Querseite (16) mit einem elektrischen Kontakt (18) zum Anschluss an eine Stromschiene ausgebildet sind.

14. Verwendung wenigstens eines Leistungsmoduls (1) nach einem der Ansprüche 1 bis 13 in einer Leistungselektronik zum Steuern einer Asynchronmaschine für einen Kurbelwellenstartergenerator.

## Claims

1. Electronic power circuit comprising several power modules (1), in particular for controlling an electric machine, each power module (1) comprising a plate-shaped integrated electronic circuit arrangement (2) with several electric terminals, **characterized in that** a vertically bent, electrically conductive side leg (3) is arranged on each of two opposite sides of the plate-shaped circuit arrangement (2), said side leg (3) forming an electric terminal, and whereby the power module (1) comprises a U-shaped cross-section, and that each side leg (3) is provided with fasteners by means of which two or more power modules (1) are electrically and mechanically fixedly connected to each other via the side legs (3) for forming the electronic power circuit, wherein the plate-shaped circuit arrangements (2) are spaced apart from each other.

2. Power circuit according to claim 1, **characterized in that** the side leg (3) comprises an outward directed projection (5) below its bend (4), said projection (5) extends parallel to the bend line and onto which another side leg (3) may be put by its underside (6), wherein the side legs (3) put onto each other partially overlap.

3. Power circuit according to claim 1 or 2, **characterized in that** the side leg (3) comprises in its bend (4) at least one recess (7) with a lip (8) arranged therein, and on its underside (6) at least one recess (9) that forms the fitting counterpart of the lip (8).

4. Power circuit according to claim 1 or 2, **characterized in that** the side leg (3) comprises on its underside (6) at least one recess (9) with an inward bent lip (19) arranged therein, and in its bend (4) a recess (7) that forms the fitting counterpart of the lip (19).

5. Power circuit according to any one of claims 1 to 4, **characterized in that** the side legs (3) arranged one above the other are electrically conductively connected by a welding or soldering process, in particular by a resistance welding process.

6. Power circuit according to any one of claims 1 to 5, **characterized in that** the side legs (3) are configured in such a manner that at least one electric component (10), in particular a capacitor, may be inserted into the space (11) that is defined by the side legs (3).

7. Power circuit according to claim 6, **characterized in that** the component (10) comprises two lateral electric contact rails (12) that may be connected in such a manner to that portion of the side legs (3) which is arranged above the bend that the component (10) is arranged above the plate-shaped circuit arrangement (2).

8. Power circuit according to claim 7, **characterized in that** elevations (13) are arranged on the side leg (3) above the bend (4), said elevations (13) serving to establish a connection to the contact rail (12) by means of projection welding.

9. Power circuit according to any one of claims 1 to 8, **characterized in that** the side legs (3) may be electrically connected to other electric components, to an electric power grid and/or to an electric load.

10. Power circuit according to any one of claims 1 to 9, **characterized in that** the circuit arrangement (2) is embedded in a synthetic material, in particular in epoxy resin or gel.

11. Power circuit according to any one of claims 1 to 10, **characterized in that** electric contacts (15), in particular power and signal contacts, are arranged on at least one of the legless sides (14) of the circuit arrangement (2).

12. Power circuit according to any one of claims 1 to 11, **characterized in that** electrically conductive connecting pins (17) for soldering onto a printed circuit board are formed on at least one transverse side (16) of the side leg (3).

13. Power circuit according to any one of claims 1 to 11, **characterized in that** an electric contact (18) for establishing a connection to a bus bar is formed on at least one transverse side (16) of the side leg (3).

14. Use of at least one power module (1) according to any one of claims 1 to 13 in an electronic power circuit for controlling an asynchronous machine for a crankshaft starter generator.

## Revendications

1. Circuit de puissance électronique composé de plusieurs modules de puissance (1), en particulier pour la commande d'une machine électrique, chaque module de puissance (1) englobant un circuit (2) électronique intégré en forme de plaque avec plusieurs connexions électriques, **caractérisé en ce que**, sur chacun de deux côtés opposés du circuit (2) en forme de plaque, il est disposé une branche latérale (3) électriquement conductrice, recourbée verticalement, qui forme une connexion électrique et par laquelle le module de puissance (1) présente une section en U, et **en ce que** chaque branche latérale (3) est munie de moyens de raccordement par lesquels deux ou plusieurs modules de puissance (1) sont raccordés fermement entre eux électriquement et mécaniquement, avec formation d'un intervalle mutuel entre les circuits (2) en forme de plaque via les branches latérales (3) pour la formation du circuit de puissance électronique.

2. Circuit selon la revendication 1, **caractérisé en ce que** la branche latérale (3) présente, au-dessous de la courbure (4), une saillie (5) disposée parallèlement à la ligne de courbure et placée debout vers l'extérieur, saillie sur laquelle une autre branche latérale (3) peut être enfichée avec le côté inférieur (6), les branches latérales (3) enfichées l'une sur l'autre se chevauchant partiellement.

3. Circuit selon la revendication 1 ou 2, **caractérisé en ce que** la branche latérale (3) présente, dans la courbure (4), au moins un creux (7) avec un bec (8) qui y est disposé et, sur le côté inférieur (6), au moins un creux (9) formant le pendant, parfaitement ajusté, au bec (8).

4. Circuit selon la revendication 1 ou 2, **caractérisé en ce que** la branche latérale (3) présente, sur le côté inférieur (6), au moins un creux (9) avec un bec (19) qui y est disposé, courbé vers l'intérieur et, dans la courbure (4), un creux (7) formant le pendant, parfaitement ajusté, au bec (19).

5. Circuit selon une des revendications 1 à 4, **caractérisé en ce que** les branches latérales (3) disposées l'une sur l'autre sont raccordées de façon électriquement conductrice par un processus de soudage ou de brasage, en particulier par un processus de soudage par résistance.

6. Circuit selon une des revendications 1 à 5, **caractérisé en ce que** les branches latérales (3) sont constituées de telle sorte que au moins un composant (10) électrique, en particulier un condensateur, peut être mis en place dans l'espace (11) délimité par les branches latérales (3).

7. Circuit selon la revendication 6, **caractérisé en ce que** le composant (10) présente deux rails de contact (12) électriques latéraux qui peuvent être raccordés avec la zone des branches latérales (3) située au dessus de la courbure de telle sorte que le composant (10) est disposé sur le circuit (2) en forme de plaque.

8. Circuit selon la revendication 7, **caractérisé en ce que**, sur la branche latérale (3), au-dessus de la courbure (4), des reliefs (13) sont disposés pour le raccordement au rail de contact (12) par soudage par bossages.

9. Circuit selon une des revendications 1 à 8, **caractérisé en ce que** les branches latérales (3) peuvent être raccordées électriquement à d'autres composants électriques, à un réseau d'alimentation en courant et/ou à un consommateur.

10. Circuit selon une des revendications 1 à 9, **caractérisé en ce que** le circuit (2) est noyé dans une matière plastique, en particulier de la résine époxyde ou un gel.

11. Circuit selon une des revendications 1 à 10, **caractérisé en ce que**, sur au moins un des côtés (14) sans branche du circuit (2), des contacts électriques (15), en particulier des contacts de puissance ou de signalisation, sont disposés.

12. Circuit selon une des revendications 1 à 11, **caractérisé en ce que** la branche latérale (3), sur au moins un côté transversal (16), sont constituées avec des broches de raccordement (17) électriquement conductrices pour le brasage sur une carte imprimée.

13. Circuit selon une des revendications 1 à 11, **caractérisé en ce que** la branche latérale (3), sur au moins un côté transversal (16), sont constituées avec un contact électrique (18) pour la connexion à une barre omnibus.

14. Utilisation d'au moins un module de puissance (1) selon une des revendications 1 à 13 dans une électronique de puissance pour la commande d'une machine asynchrone pour un générateur de démarreur de vilebrequin.
